Europäisches Patentamt

European Patent Office

Office européen des brevets

(19)

(11)  EP 0 732 703 B1

(12)  **EUROPÄISCHE PATENTSCHRIFT**

(45) Veröffentlichungstag und Bekanntmachung des
Hinweises auf die Patenterteilung:
**23.05.2001   Patentblatt 2001/21**

(51) Int Cl.⁷: **G11C 29/00**

(21) Anmeldenummer: **95103791.0**

(22) Anmeldetag: **15.03.1995**

(54) **Verfahren zur Überprüfung einer Halbleiter-Speichervorrichtung**

Method for testing a semiconductor memory circuit

Procédé pour tester un circuit de mémoire à semi-conducteur

(84) Benannte Vertragsstaaten:
**AT DE FR GB IE IT NL**

(43) Veröffentlichungstag der Anmeldung:
**18.09.1996   Patentblatt 1996/38**

(73) Patentinhaber: **Infineon Technologies AG
81669 München (DE)**

(72) Erfinder:
• **Rieger, Johann
D-93199 Zell (DE)**

• **von der Ropp, Thomas, Dr.
D-82110 Germering (DE)**

(74) Vertreter: **Zedlitz, Peter, Dipl.-Inf. et al
Patentanwalt,
Postfach 22 13 17
80503 München (DE)**

(56) Entgegenhaltungen:
**EP-A- 0 387 379          EP-A- 0 411 594
US-A- 4 409 676          US-A- 4 816 757**

**Beschreibung**

Die Erfindung bezieht sich auf ein Verfahren zur Überprüfung einer auf einem Halbleiterchip integriert ausgebildeten Halbleiter-Speichervorrichtung mit einer Vielzahl von auf einem Halbleitersubstrat angeordneten Speicherzellen für je einen binären Informationswert, wobei das Verfahren zur Überprüfung durch zeitweises Verändern zumindest einer chip-internen Referenzspannung und Erfassen und Bewerten der bei der geänderten Referenzspannung ausgelesenen Informationswerte durchgeführt wird.

Mit zunehmender Komplexität und Speichertiefe einer auf einem Halbleiterchip integriert ausgebildeten Halbleiter-Speichervorrichtung, insbesondere einer dynamischen Halbleiter-Speichervorrichtung mit wahlfreiem Zugriff (sogenannter DRAM) werden die zur Überprüfung der Funktionsfähigkeit der Halbleiter-Speichervorrichtung vorzugsweise vor der Verkapselung des Halbleiterchips in ein Gehäuse durchzuführenden Testverfahren bzw. unter Verwendung eines Rechners durchzuführenden Testprogramme immer umfangreicher und die Testzeiten der einzelnen Tests immer länger, so daß die Durchführung des Tests einen immer größeren Aufwand erfordert. Der Zweck eines derartigen Verfahrens bzw. Testprogramms liegt neben der Überprüfung des Speicherchips auf prinzipielle Funktionstüchtigkeit bei ausreichenden Margins insbesondere darin, fehlerhafte oder schwache Speicherzellen aufzuspüren, um diese gegebenenfalls mit Hilfe von auf dem Chip zusätzlich vorhandenen Redundanzzellen zu ersetzen. Hierbei sind integrierte Halbleiter-Speicherschaltungen, insbesondere solche vom 1-Transistor-Speicherzellentyp, empfindlich gegenüber sogenannten Soft-Errors, d.h. gegenüber Alphastrahlen, die meist vom verwendeten Bausteingehäuse herrühren. Versuche haben gezeigt, daß die Halbleiter-Speicherschaltungen unterschiedlich stark auf diese Alphastrahlen reagieren, je nachdem, ob ein Informationswert als physikalische 0 oder als physikalische 1 zu speichern war (eine physikalische 0 kann einem Wert logisch 0 entsprechen; sie kann aber auch einem Wert logisch 1 entsprechen, wobei die Zuordnung von der jeweils gewählten Schaltungstechnik abhängig ist). Es hat sich herausgestellt, daß dies Folge einer sogenannten Bewertungsunsymmetrie der Leseverstärker ist, so daß z.B. ein gespeichertes Datum physikalisch 0 nicht mit derselben Sicherheit und denselben Sicherheitsmargins auslesbar ist wie ein gespeichertes Datum physikalisch 1 und umgekehrt. Damit jedoch nimmt die Gefahr des Auftretens von Soft-Errors bezüglich der einen Datumsart zu, während sie gegenüber der anderen Datumsart abnimmt. Demgemäß ist auch die Erfassung von fehlerhaften oder schwachen Speicherzellen in Abhängigkeit der beiden Datumsarten aufwendig. Speicherzellen, die somit prozeßbedingt (z.b. partikelinduziert) ein schlechteres Lesesignal liefern, können bisweilen durch die herkömmlichen Testprogramme nicht vollständig erfaßt und ausselektiert werden, stellen jedoch beim Kunden ein potentielles Risiko dar, da sie unter speziellen Bedingungen doch zum Ausfall führen können. Dies verschlechtert unmittelbar die Qualität der ausgelieferten Ware. Zur Lösung dieses Problems wurden die bisher zum Einsatz kommenden Verfahren bzw. Testprogramme zur Überprüfung der Halbleiter-Speichervorrichtung verlängert und verschärft. Zum einen erfordern derartig umfangreiche Prüfprogramme jedoch einen erheblichen Zeitaufwand zur vollständigen Überprüfung einer Halbleiter-Speichervorrichtung; zum anderen hat sich wenigstens zum Teil gezeigt, daß der selbst bei umfangreichen Prüfprogrammen erzielbare Ausselektionsgrad nicht besonders hoch bzw. ausreichend ist.

Aus der US 4,816,757 ist ein für verbessertes Testen in seiner Herstellungsumgebung umkonfigurierbarer integrierter Schaltkreis nach dem Oberbegriff des Hauptanspruchs bekannt geworden, bei dem bei normaler Betriebsweise an ein in Spalten und Zeilen angelegtes Speicherzellenfeld zur Selektion und Deselektion von Speicherzellen definierte Spannungen an Zeilenleitungen angelegt werden und bei Betriebsweise in einem Testmode die Zeilenleitungen anstelle der definierten Spannungen mit einer von außen an den Speicher angelegten erhöhten Spannung beaufschlagt werden. Nachteilig hierbei ist, daß durch das vorgeschlagene Überladen der Speicherzellen-Kondensatoren vermittels einer festen gegenüber der normalen Ladespannung erhöhten Spannung auch eine erhöhte Leistung durch die Schaltung aufgenommen wird, die betroffenen Bauteile müssen dann entsprechend der erhöhten Spannung so dimensioniert werden, daß sie keinen Schaden nehmen. Um die erhöhten Spannungen zu schalten ist bei der vorgeschlagenen Speicherschaltung zusätzlicher Aufwand notwendig. Durch die bekannte Vorgehensweise wird die Speicherkapazität als bestimmender Faktor gewählt, wodurch nicht alle Defekte, insbesondere auch der der Speicherzelle zugeordneten Bauteile, bestimmt werden können.

Aus der EP-A 387 379 ist ein Verfahren zum Testen eines integrierten Halbleiterspeichers vom Typ DRAM bekannt geworden, bei dem in einem Testmode die Vorlade-Spannungen auf den Bitleitungen des Speichers mit Hilfe eines über Koppelkondensatoren auf diese eingekoppelten Testsignals erhöht werden.

Aus der EP-A 411 594 ist ein Verfahren zur Funktionssicherheitsprüfung für integrierte Halbleiterspeicher bekannt geworden, mit elektrisch voneinander getrennten Spannungsversorgungsleitungen einerseits für die Speicherzellen und andererseits für die Treiberstufen und Auswahlleitungen, wobei durch eine Spannungsdifferenz auf den Spannungsversorgungsleitungen eine Änderung des Durchgangswiderstands der die Speicherzellen an die Datenleitungen ankoppelnden Tortransistoren erreicht wird.

Der vorliegenden Erfindung liegt die Aufgabe zugrunde, ein einfaches und ohne großen Zeit- und Arbeitsaufwand durchzuführendes Verfahren zu Überprüfung einer auf einem Halbleiterchip integriert ausgebildeten Halbleiter-Speichervorrichtung anzugeben, welche eine möglichst vollständige Erfassung und Ausselektion schadhafter oder schwacher Speicherzellen ermöglicht.

Diese Aufgabe wird erfindungsgemäß gelöst durch das Verfahren nach Anspruch 1. Auf diese Weise verringert sich bei der Absenkung der chip-internen Referenzspannung das Lesesignal physikalischer Speicherwerte, so daß Speicherzellen mit verringerter Ladekapazität oder anderen Defekten hierbei für eine sichere Bewertung ein zu kleines Lesesignal liefern und aus diesem Grund in einfacher Weise als schwache bzw. fehlerhafte Speicherzellen erkannt und gegebenenfalls durch Redundanzzellen ersetzt werden können. Zur Bestimmung der Defekte sind hierzu keine zusätzlichen Schaltungselemente oder besondere zusätzliche Signal-Pegel notwendig. Die Bestimmung der schadhaften Speicherzellen oder Bauelemente gelingt durch die Verringerung der Ladung, da schwache Kondensatoren nun unter die Schaltschwelle zur sicheren Pegelbestimmung fallen und sicher als schadhaft detektiert werden können. Auch andere betroffene Parameter bzw. Komponenten der Speicherzelle oder der ihr zugeordneten Schaltungselemente (Datenleitungen, Transistoren, Verstärker, ...) können ebenso sicher bezüglich verringerter Pegel bzw. bezüglich der Schalschwellen mitgetestet werden. Durch das Absenken und Erhöhen der chip-internen Referenzspannung mit einem Funktionsmuster können weitere Defekte detektiert werden, da das Verhalten an den Flanken bzw. Schaltschwellen bei der Bewertung von logischen Einsen und Nullen unterschiedlich ist. Außerdem können mit der in einem Testlauf nach dem Funktionsmuster vorgenommenen Verringerungen bzw. Erhöhungen mehrere Testschritte (Erhöhen und Erniedrigen) in einem Test vorgenommen werden. Was die Testdurchlaufzeiten erhöht und somit kostbare Produktionszeit einspart.

Zur Durchführung des erfindungsgemäßen Verfahrens ist es erforderlich, daß die chip-interne Referenzspannung von außen vorübergehend oder permanent verändert (gegenüber dem vorbestimmten Normalwert vergrößert bzw. verringert) und/oder eingestellt werden kann. Dies kann entweder durch Einprägen oder durch Programmieren der chip-internen Referenzspannung von außen an einem geeigneten Anschluß-Pad erfolgen, oder über sogenannte Fuses (Lichtfuses, Laserfuses, elektrische Fuses oder dergleichen), die als irreversible Schalter auf dem Chip in Form von redundanten Leitungsverbindungen ausgebildet sind, die bei Bedarf durchtrennt werden können, oder innerhalb eines Testmodus vorgenommen werden. In jedem Fall kann durch relativ einfach durchzuführendes Verändern der chip-internen Referenzspannung ein gegenüber den vorbekannten Prüfverfahren schnelleres Verfahren zur Überprüfung schadhafter Speicherzellen mit einem ausreichend hohen Ausselektionsgrad durchgeführt werden.

In einer besonders bevorzugten Ausführung des erfindungsgemäßen Verfahrens wird die chip-interne Referenzspannung die Versorgungsspannung VDC sogenannter Dummy-Speicherzellen verwendet. Bei integrierten Halbleiterspeicherschaltungen ist es allgemein üblich, vor einem Auslesen von Daten aus den Speicherzellen die Bitleitungen auf ein Bitleitungspotential VBL vorzuladen (allgemein als Precharge-Vorgang bzw. mit Precharge-Potential bezeichnet). Dies dient dazu, den Leseverstärkern, welche im allgemeinen Flip-Flop-Schaltungen darstellen, die differenziell arbeiten, nach dem Auslesen zur Bewertung und Verstärkung der Lesesignale effektiv nur diese zuzuführen, da das Bitleitungspotential VBL an beiden Eingängen der Leseverstärker mit demselben Wert anliegt und somit von den differenziell arbeitenden Leseverstärkern nicht berücksichtigt wird. Üblicherweise wird als Bitleitungspotential VBL ein Wert angelegt, der der halben Differenz aus Versorgungsspannungspotential VDD und Bezugspotential VCC entspricht bzw. bei solchen Halbleiterspeicherschaltungen, die schaltungsintern mit einem gegenüber dem am fertigen Baustein anliegenden Versorgungspotential erniedrigten sogenannten internen Versorgungsspannungspotential VDDint arbeiten, legt man die entsprechende halbe Differenz zwischen diesem internen Versorgungsspannungspotential VDDint und dem Bezugspotential VSS an. Soweit die Halbleiterspeicherschaltung auch die vorstehend genannten Dummy-Speicherzellen aufweist, werden in der Regel auch diese auf das Bitleitungspotential VBL aufgeladen. Bei solchen Halbleiterspeicherschaltungen mit Dummy-Speicherzellen hat sich herausgestellt, daß diese effektiv durch Ändern der chip-internen Dummy-Zellen-Versorgungsspannung VDC überprüft werden können.

Nachstehend wird die Erfindung anhand einer Figur erläutert, welche auch vorteilhafte Weiterbildungen enthält .

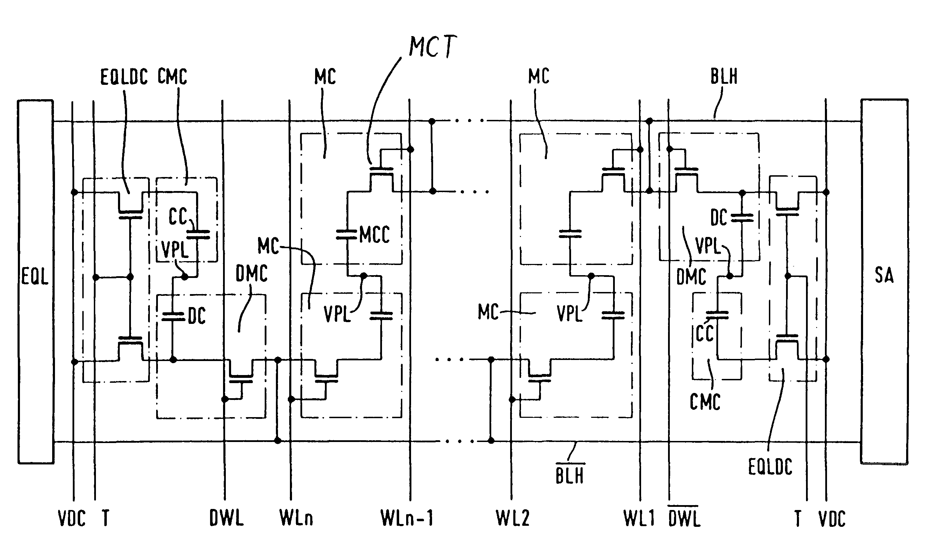

Die Figur zeigt einen Ausschnitt aus einer beispielhaften Halbleiterspeicherschaltung, bei der das erfindungsgemäße Verfahren zur Überprüfung von Speicherzellen angewendet werden kann. Gezeigt ist eine Bitleitung mit ihren beiden Bitleitungshälften BLH, $\overline{BLH}$, an die auf der einen Seite ein Leseverstärker SA angeschlossen ist und auf der anderen Seite eine Vorlageeinrichtung EQL zum Vorladen und (bezüglich ihres elektrischen Potentials) Gleichsetzen der Bitleitungshälften BLH, $\overline{BLH}$ auf ein Bitleitungspotential VBL vor einem Auslesen von Daten aus Speicherzellen MC. Weiterhin sind Speicherzellen MC vom 1-Transistor-Typ gezeigt (mit Auswahltransistoren MCT und Speicherkondensatoren MCC), die einerseits mit der jeweiligen Bitleitungshälfte BLH, BLH verbunden sind und andererseits (an den ersten Elektroden ihrer Speicherkondensatoren MCC) alle gemeinsam mit einem sogenannten Plattenpotential VPL. Dieses weist im wesentlichen den halben Wert der Differenz aus Versorgungsspannungspotential VDD (bzw. internem Versorgungsspannungspotential VDDint) und Bezugspotential VSS auf.

Es ist somit im wesentlichen gleich dem Bitleitungspotential VBL, welches über die Vorladeeinrichtung EQL an die Bitleitungen BL anlegbar ist. Das Plattenpotential VPL könnte auch, wie in der Vergangenheit üblich, im wesentlichen den Wert des Versorungsspannungspotentials VDD (bzw. den des internen Versorgungsspannungspotentials VDDint) oder des Bezugspotentials VSS aufweisen. Weiterhin zeigt die Figur T Wortleitungen WL (durchnumeriert von WL1 bis WLn) zur Ansteuerung der Auswahltransistoren MCT der Speicherzellen MC.

Die Speicherzellen MC sind also, wie allgemein üblich, an Kreuzungspunkten zwischen Wortleitungen WL und Bitleitungen angeordnet und über ihre Auswahltransistoren MCT zum Lesen und Speichern von Informationen mit den jeweiligen Bitleitungen bzw. Bitleitungshälften BLH; $\overline{BLH}$ verbindbar. Jede Bitleitungshälfte BLH, $\overline{BLH}$ weist (beispielsweise, wie dargestellt, an ihren Enden angeordnet) eine sogenannte Dummy-Zelle DMC auf, die ebenfalls vom 1-Transistor-Zellentyp ist. Dies dient einer gleichmäßigen und symmetrischen Belastung der differenziell arbeitenden Leseverstärker SA im Betrieb. Auch die Speicherkondensatoren DC der Dummy-Zellen DMC sind an ihren ersten Elektroden mit dem Plattenpotential verbunden. Ferner weist diese Halbleiterspeicherschaltung Vorrichtungen EQLDC auf, mittels deren die jeweils zweiten Elektroden der Speicherkondensatoren DC der Dummy-Speicherzellen DMC im Betrieb mit einerm Vorladepotential VDC beaufschlagbar sind. Das Beaufschlagen erfolgt während des (üblichen) Vorladens der Bitleistungen BL auf das Bitleitungspotential VBL. Der Wert des Vorladepotentials VDC ist vorzugsweise 5 bis 35% größer als der Wert der halben Differenz aus Versorgungsspannungspotential VDD (bzw. VDDint bei Verwendung eines internen Versorgungsspannungspotentials) und Bezugspotential VSS.

Die Vorrichtungen EQLDC können beispielsweise, wie dargestellt, Transistoren enthalten, die einerseits mit dem Vorladepotential VDC und andererseits mit den zweiten Elektroden der Speicherkondensatoren DC der Dummy-Zellen DMC verbunden sind. Die Transistoren sind gatemäßig von einem Vorladetaktsignal T angesteuert, welche im Zeitpunkt des Vorladens die Transistoren leitend schalten. Das Vorladetaktsignal T kann denselben zeitlichen Verlauf aufweisen wie ein entsprechendes (nicht näher dargestelltes) Taktsignal, welches vor einem Auslesen von Daten aus den Speicherzellen MC das Vorladen der Bitleistungen BL auf ihr Bitleistungspotential VBL steuert.

Die Figur zeigt des weiteren Randzellen CMC, welche im allgemeinen als "friendly cells" bezeichnet werden. Ihre Funktion ist dem Fachmann an sich bekannt. Sie können entweder lediglich aus Randzellenkondensatoren CC bestehen, wie hier dargestellt. Sie können aber auch darüber hinaus noch Transistoren enthalten, ähnlich den Auswahltransistoren MCT von Speicherzellen MC oder denen von Dummy-Zellen DMC. In vorteilhafter Weise sind die ersten Elektroden der Randzellenkondensatoren CC mit dem Plattenpotential VPL verbunden und die zweiten Elektroden dieser Randzellenkondensatoren CC sind mittels der Ausgleichsvorrichtungen EQLDC für die Dummy-Zellen DMC ebenfalls mit dem Vorladepotential VDC der Dummy-Zellen DMC beaufschlagbar. Dies ergibt dann eine noch bessere Symmetriesierung der Arbeits- und Belastungsverhältnisse der Leseverstärker SA beim Auslesen sowie Bewerten und Verstärken des ausgelesenen Daten.

**Patentansprüche**

1. Verfahren zur Überprüfung einer auf einem Halbleiterchip integriert ausgebildeten Halbleiter-Speichervorrichtung mit einer Vielzahl von auf einem Halbleitersubstrat angeordneten Speicherzellen (MC) für je einen binären Informationswert, wobei das Verfahren zur Überprüfung durch zeitweises Verändern zumindest einer chip-internen Referenzspannung (VDC) und Erfassen und Bewerten der bei der geänderten Referenzspannung (VDC) ausgelesenen Informationswerte durchgeführt wird, **dadurch gekennzeichnet,** daß über Datenleitungen (BLH) Informationswerte ausgelesen und eingeschrieben werden und mit den Speicherzellen (MC) zugeordneten Tortransistoren (MCT) Datenwege zwischen einer jeweiligen Speicherzelle und einer Datenleitung (BLH) selektiv freigegeben werden, welche Tortransistoren mit Auswahlleitungen (WLn) gezielt angesteuert werden und daß die chip-interne Referenzspannung (VDC) mit einem vorgegebenen bzw. vorgebbaren Funktionsmuster zeitabhängig gegenüber dem Normalwert der Referenzspannung (VDC), den sie im bestimmungsgemäßen, nicht zur Überprüfung vorgesehenen Normal-Betrieb der Halbleiter-Speichervorrichtung einnimmt, abgesenkt und wieder angehoben wird.

2. Verfahren zur Überprüfung einer auf einem Halbleiterchip integriert ausgebildeten Halbleiter-Speichervorrichtung nach Anspruch 1, **dadurch gekennzeichnet,** daß das zeitweise Verändern der chip-internen Referenzspannung (VDC) von außerhalb des Chips durchgeführt wird.

3. Verfahren zur Überprüfung einer auf einem Halbleiterchip integriert ausgebildeten Halbleiter-Speichervorrichtung nach Anspruch 1 oder 2, **dadurch gekennzeichnet,** daß das zeitweise Verändern der chip-internen Referenzspannung (VDC) durch Einstellen geeigneter Fuses, die auf dem Halbleiterchip integriert ausgebildet sind, durchgeführt wird.

**4.** Verfahren zur Überprüfung einer auf einem Halbleiterchip integriert ausgebildeten Halbleiter-Speichervorrichtung nach Anspruch 1 bis 3,
**dadurch gekennzeichnet,**
daß die chip-interne Referenzspannung (VDC) die Dummy-Speicherzellen-Versorgungsspannung für auf dem Halbleiterchip integriert ausgebildete Dummy-Speicherzellen (DMC) darstellt.

## Claims

**1.** Method for testing a semiconductor memory device integrated on a semiconductor chip and having a multiplicity of memory cells (MC), arranged on a semiconductor substrate, for a respective binary information value, the testing method being carried out by occasionally altering at least one on-chip reference voltage (VDC) and detecting and evaluating the information values that are read out in the case of the changed reference voltage (VDC),
characterized
in that information values are read out and written in via data lines (BLH) and gate transistors (MCT) assigned to the memory cells (MC) are used to selectively enable data paths between a respective memory cell and a data line (BLH), which gate transistors are driven in a targeted manner by means of select lines (WLn), and in that the on-chip reference voltage (VDC) is lowered and raised again with a predetermined or predeterminable fuction pattern in a time-dependent manner relative to the normal value of the reference voltage (VDC), which it assumes during the intended normal operation, not provided for testing, of the semiconductor memory device.

**2.** Method for testing a semiconductor memory device integrated on a semiconductor chip according to Claim 1,
characterized
in that the occasional alteration of the on-chip reference voltage (VDC) is carried out from outside the chip.

**3.** Method for testing a semiconductor memory device integrated on a semiconductor chip according to Claim 1 or 2,
characterized
in that the occasional alteration of the on-chip reference voltage (VDC) is carried out by setting suitable fuses integrated on the semiconductor chip.

**4.** Method for testing a semiconductor memory device integrated on a semiconductor chip according to Claims 1 to 3,
characterized
in that the on-chip reference voltage (VDC) constitutes the dummy memory cell supply voltage for dummy memory cells (DMC) integrated on the semiconductor chip.

## Revendications

**1.** Procédé pour tester un circuit de mémoire à semiconducteur intégré sur une puce de semi-conducteur avec une pluralité de cellules de mémoire (MC) agencées sur un substrat semi-conducteur pour chaque fois une valeur binaire d'information, le procédé de test étant réalisé par modification temporaire d'au moins une tension de référence (VDC) interne à la puce et par saisie et estimation des valeurs d'information extraites au moment de la tension de référence modifiée (VDC),
caractérisé en ce que
des valeurs d'information sont extraites et inscrites au moyen de lignes de données (BLH) et des chemins de données entre une cellule de mémoire respective et une ligne de données (BLH) sont libérés de manière sélective avec les transistors à porte (MCT) affectés aux cellules de mémoire (MC), lesquels transistors à porte sont spécifiquement commandés avec des lignes de sélection (WLn), et en ce que la tension de référence (VDC) interne à la puce est diminuée et à nouveau augmentée avec un modèle de fonction prédéterminé ou pouvant être prédéterminé, en fonction du temps par rapport à la valeur normale de la tension de référence (VDC), qu'elle prend en fonctionnement normal conforme, non prévu pour le test, du circuit de mémoire à semi-conducteur.

**2.** Procédé pour tester un circuit de mémoire à semiconducteur intégré sur une puce de semi-conducteur selon la revendication 1,
caractérisé en ce que
la modification temporaire de la tension de référence (VDC) interne à la puce est réalisée de l'extérieur de la puce.

**3.** Procédé pour tester un circuit de mémoire à semiconducteur intégré sur une puce de semi-conducteur selon la revendication 1 ou 2,
caractérisé en ce que
la modification temporaire de la tension de référence (VDC) interne à la puce est réalisée par le réglage de fusibles appropriés qui sont s intégrés sur la puce de semi-conducteur.

**4.** Procédé pour tester un circuit de mémoire à semiconducteur intégré sur une puce de semi-conducteur selon la revendication 1 à 3,
caractérisé en ce que
la tension de référence (VDC) interne à la puce représente la tension d'alimentation des cellules ficti-

**EP 0 732 703 B1**

ves de mémoire pour des cellules fictives de mémoire (DMC) intégrées sur la puce de semi-conducteur.

SA

BLH

DC VPL DMC CC CMC EQLDC T VDC

MC $\overline{BLH}$ VPL $\overline{DWL}$ WL1 WL2

MCT

MCC VPL MC WLn-1 WLn

EQLDC CMC CC VPL DC DMC DWL VDC T

EQL